# EUROPÄISCHE PATENTSCHRIFT

(11) **EP 1 042 389 B1**
(45) Veröffentlichungstag und Bekanntmachung des Hinweises auf die Patenterteilung: **09.04.2003**
(21) Anmeldenummer: 98966528.6
(22) Anmeldetag: 11.12.1998
(51) Int. Cl.: C08G 77/06, C08L 83/04, H01L 23/552, H01L 23/66, C08K 3/08

(54) **VERWENDUNG EINES SILIKONKAUTSCHUKS ZUR HERSTELLUNG EINES ABSORBERMATERIALS**
USE OF A SILICONE RUBBER FOR PRODUCING AN ABSORBER MATERIAL
UTILISATION D'UN CAOUTCHOUC DE SILICONE DANS LA PRODUCTION D'UN MATERIAU ABSORBANT

(30) Priorität: 19.12.1997 DE 19756620
(43) Veröffentlichungstag der Anmeldung: 11.10.2000
(73) Patentinhaber: ROBERT BOSCH GMBH, 70442 Stuttgart (DE)
(72) Erfinder: BOVENSIEPEN, Kurt, D-71364 Winnenden (DE); PIEPER, Mathias, D-74354 Besigheim (DE); SPACHMANN, Detlef, D-71522 Backnang (DE)
(86) Internationale Anmeldenummer: DE9803635
(87) Internationale Veröffentlichungsnummer: WO99032538

(56) Entgegenhaltungen:
- EP-A- 0 254 153
- EP-A- 0 380 267
- EP-A- 0 769 528
- DE-A- 3 827 487
- US-A- 5 166 293

## Beschreibung

Die vorliegende Erfindung betrifft die Verwendung eines additionsvernetzten Silikonkautschuks zur Herstellung eines Absorbermaterials, sowie eine Halbleiteranordnung in einem hermetisch dichten Gehäuse, in dem das erfindungsgemäße Absorbermaterial angeordnet ist.

### Stand der Technik

Offene Halbleiter werden unter anderem in hermetisch dichten Gehäusen eingesetzt. In diesen Gehäusen befindet sich unter anderem Absorbermaterial, um die in dem Gehäuse entstehenden hohen Frequenzen zu absorbieren. Üblicherweise wird als Absorbermaterial eisengefüllter Silikonkautschuk eingesetzt.

Die Herstellung des Absorbermaterials, das heißt des Silikonkautschukes, erfolgt durch Additionsvernetzung einer Komponente A und einer Komponente B, wobei die Komponente A ein Polydiorganosiloxan, insbesondere mit der allgemeinen Formel -O-SiR₁R₂CH=CH₂, und die Komponente B Wasserstoffsiloxan, insbesondere mit der allgemeinen Formel -O-SiHCH₃R ist, wobei R, R₁ und R₂ gleiche oder ungleiche Kohlenwasserstoffreste und/oder H sind. Das Polydiorganosiloxan weist für Vernetzungsreaktionen zugängliche Gruppen auf, insbesondere Vinylgruppen, die sich an den Kettenenden befinden, oder in die Kette eingebaut sein können. Durch eine durch beispielsweise Edelmetalle oder Edelmetallverbindungen, insbesondere Palladium, katalysierte Addition von SiH-Gruppen an die silizium-gebundenen Vinylgruppen wird der als Absorbermaterial eingesetzte additionsvernetzte Silikonkautschuk, insbesondere der allgemeinen Formel -O-SiR₁R₂-CH₂-CH₂-SiRCH₃-Ohergestellt. Dabei werden bei der Herstellung des additionsvernetzten Silikonkautschuks die SiH-Gruppen in Form der Komponente B, also insbesondere als Wasserstoffsiloxan bereitgestellt, welches im ausgehärteten Silikonkautschuk, also im Absorbermaterial, als Weichmacher dient.

Dieses Absorbermaterial emittiert im Lauf der Zeit molekularen Wasserstoff, insbesondere bei hohen Temperaturen oder unter dem Einfluß von Feuchtigkeit. Bei offenen Gehäusen kann der Wasserstoff entweichen. In hermetisch dichten Gehäusen reagiert der Wasserstoff jedoch mit dem Halbleiter und setzt damit die Lebensdauer des Bauelementes herab.

Bekannt ist es daher, einen irreversiblen sogenannten-Wasserstoffgetter in das hermetisch dichte Gehäuse einzusetzen. Der entstehende Wasserstoff wird durch das Gettermaterial aufgefangen, so daß weniger Wasserstoff an den Halbleiter gelangt. Der Wasserstoffgetter weist als Träger ebenfalls Silikon auf, wobei das eigentliche Gettermaterial eine organische Verbindung darstellt, die mittels des Katalysators Palladium Wasserstoff irreversibel aufnimmt. Aufgrund des hohen Preises des Wasserstoffgetters findet dieser insbesondere in Deutschland keine Anwendung.

Eine andere Möglichkeit, den oben beschriebenen Verschleiß des Halbleiters aufgrund der Wasserstoffbildung zu verhindern, besteht im Tempern des Absorbermaterials. Gemäß diesem Verfahren wird das eisengefüllte Absorbermaterial vor dem Verschließen des Gehäuses 48 Stunden bei 200°C getempert. Wasser und Wasserstoff werden aus dem Absorbermaterial ausgetrieben, so daß im Gehäuse kein Wasserstoff entstehen kann. Als nachteilig erweist sich jedoch, daß dieses Verfahren kosten- und zeitintensiv ist. Zudem muß das getemperte Absorbermaterial unter Schutzgas aufbewahrt werden und darf nicht mit Luftfeuchtigkeit in Kontakt treten. Schließlich werden die mechanischen Eigenschaften des Absorbermaterials durch das Tempern wesentlich verschlechtert und es kommt zu elektrischen Dichtproblemen beim Abdichten der Gehäuse.

### Vorteile der Erfindung

Die vorliegende Erfindung stellt ein Verfahren zur Herstellung eines Absorbermaterials aus einer Komponente A, insbesondere einem Polyorganosiloxan, vorzugsweise einem Polydiorganosiloxan, und einer Komponente B, insbesondere einem SiH-haltigen Härter, zur Verfügung, wobei in einem ersten Verfahrensschritt der SiH-haltige Härter dem Polyorganosiloxan im Unterschuß zugesetzt und in einem zweiten Verfahrensschritt ein ausgehärteter Silikonkautschuk erhalten wird.

Im Zusammenhang mit der vorliegenden Erfindung wird unter einem SiH-haltigen Härter eine Verbindung verstanden, die Polyorganosiloxane mittels seiner SiH-Gruppen miteinander vernetzen kann.

Im Zusammenhang mit der vorliegenden Erfindung wird unter einem Unterschuß an SiH-haltigem Härter eine Menge an Härter verstanden, gemäß der im ausgehärteten additionsvernetzten Silikionkautschuk keine oder nur sehr wenig überschüssige, das heißt nicht vernetzte, Siliziumwasserstoffgruppen vorliegen. Die Erfindung sieht insbesondere vor, das Absorbermaterial so herzustellen, daß keine oder nur sehr wenige überschüssige Siliciumwasserstoffgruppen im ausgehärteten Silikonkautschuk vorliegen. Dies kann erfindungsgemäß durch Erhöhung der Aushärtetemperatur und/oder Zugabe einer im Vergleich zur herkömmlicherweise verwendeten Menge reduzierten Menge der Komponente B bei der Herstellung des Absorbermaterials geschehen.

Die herkömmlicherweise von den Herstellern von Absorbermaterialien vorgeschlagenen Härtermengen führen nämlich zu einem Überschuß an Härter im additionsvernetzten Silikonkautschuk, so daß überschüssige, nicht vernetzte Siliziumwasserstoffgruppen vorliegen, die mit Wasser molekularen unerwünschten Wasserstoff bilden. Der Vorgang läßt sich formeimäßig wie folgt darstellen: -[SiCH₃HO]ₙ- + nH₂O → -[SiCH₃(OH)O]ₙ- + nH₂. Das bei dieser Reaktion entstehende Polymethylhydroxysiloxan kann durch Polykondensation mit einem benachbarten Molekül ebenfalls Wasser abspalten und dabei die vorgenannte Reaktion, also die Wasserstoffabspaltung, weiter in Gang halten.

Die von den Herstellern dieser Absorbermaterialien vorgeschlagenen Härtermengen können erfindungsgemäß um ca. 40 bis 50% reduziert werden. Insbesondere sieht die Erfindung vor, daß ein Verhältnis von Polyorganosiloxan zu SiH-haltigem Härter von 30:1 bis 15:1, besonders bevorzugt von 26:1 bis 18:1, insbesondere von 9:0,35, 10:0,4, 9,04, 10:0,5 oder 9:0,5 (Angaben in Gew.-%) eingesetzt wird.

Die Erfindung weist den Vorteil auf, daß der Wasserstoff nicht mehr nach seiner Bildung entfernt, sondern vielmehr dessen Bildung von vornherein verhindert wird. Die Erfindung weist insbesondere den Vorteil auf, daß die potentielle Wasserstoffemission um 95% reduziert werden kann und daß sowohl bei Absorbermaterialien mit als auch ohne Eisenpulver kein Wasserstoff bei einer Empfindlichkeit von 0,1 ppm nachgewiesen werden konnte. Bis zu dieser Temperatur besteht die Sicherheit, daß kein Wasserstoff frei wird, der die Halbleiter beschädigen könnte. Unter anderem aufgrund der geringeren Menge an eingesetztem Härter kann das Absorbermaterial kostengünstiger hergestellt werden. Zudem ergeben sich insbesondere im Hinblick auf das bekannte Temperverfahren Zeitersparnisse in der Fertigung. In vorteilhafter Weise werden schließlich die an das erfindungsgemäß hergestellte Absorbermaterial gestellten mechanischen Erfordernisse, wie Temperaturbeständigkeit, Shore-A-Härte etc. erfüllt.

In einer besonders bevorzugten Ausführungsform der vorliegenden Erfindung wird das vorgenannte Verfahren so durchgeführt, daß im zweiten Verfahrensschritt, das heißt bei der Aushärtung, eine Temperatur von 140 bis 180°C, vorzugsweise von 150°C, über einen Zeitraum von 0,5 bis 3 Stunden, vorzugsweise von 1 Stunde, eingestellt wird. Die gegenüber der herkömmlich verwendeten Aushärtetemperatur von ca. 80°C erhöhte erfindungsgemäße Aushärtetemperatur führt zu einer nochmals verringerten Wasserstoffbildung.

Selbstverständlich betrifft die vorliegende Erfindung auch die Verwendung eines additionsvernetzten Silikonkautschuks als Absorbermaterial, bei dessen Herstellung aus einer Komponente A, einem Polyorganosiloxan, zum Beispiel Polydiorganosiloxan, und einer Komponente B, einem SiH-haltigen Härter, in einem ersten Verfahrensschritt der SiH-haltige Härter dem Polyorganosiloxan zugesetzt und in einem zweiten Verfahrensschritt bei einer Temperatur von 140 bis 180°C, vorzugsweise von 150°C, über einen Zeitraum von 0,5 bis 3 Stunden, vorzugsweise von 1 Stunde, die Aushärtung durchgeführt und ein ausgehärteter additionsvernetzter Silikonkautschuk erhalten wird. Erfindungsgemäß kann die Wasserstoffemission also sowohl durch die Maßnahme, den Härter im Unterschuß zuzusetzen als auch durch die Maßnahme, die Aushärtetemperatur zu erhöhen, verhindert werden. Wie beschrieben, ist selbstverständlich auch die Kombination beider Maßnahmen möglich. Beide Maßnahmen, allein oder in Kombination, führen zur Herstellung eines verbesserten additionsvernetzten Silikonkautschuk, der dadurch gekennzeichnet ist, daß er im wesentlichen keine freien SiH-Gruppen aufweist.

Die Erfindung betrifft auch die vorgenannten Verwendungen , wobei der additionsvernetzte Silikonkautschuk mit Eisenpulver gefüllt ist. Dies ist insbesondere deshalb vorteilhaft, weil das Eisenpulver selbst ein sehr guter Wasserstofffänger ist.

Gemäß einer besonders bevorzugten Ausführungsform der Erfindung wird als Härter Wasserstoffsiloxan, vorzugsweise der Summenformel CH₃-[SiHCH₃O]ₓ-CH₃ mit x ≥ 1 eingesetzt.

Die Erfindung betrifft auch eine Halbleiteranordnung umfassend einen in einem hermetisch dichten Gehäuse angeordneten Halbleiter, wobei in dem Gehäuse ein Absorbermaterial gemäß der vorliegenden Erfindung als Dämpfungsmasse angeordnet ist.

Weitere vorteilhafte Ausgestaltungen der Erfindung ergeben sich aus den Unteransprüchen.

Die Erfindung wird anhand der nachstehenden Ausführungsbeispiele näher erläutert.

### Beispiel 1: Bestimmung der SiH-Konzentration

Wie beschrieben, ist die Siliziumwasserstoffgruppe des Härters verantwortlich für die unerwünschte Wasserstoffemission. Je mehr freie Siliziumwasserstoffgruppen im ausgehärteten Silikonkautschuk vorhanden sind, um so mehr Wasserstoff kann entstehen. Eine Methode zur Bestimmung der SiH-Konzentration ist die mittels FTIR. Die SiH-Gruppe weist einen eindeutigen Peak bei einer Wellenzahl von 2160 cm⁻¹ auf. Die gemessene Absorption ist proportional zur Konzentration der SiH-Gruppen. Die Extinktion, das heißt die Peakhöhe, stellt den linearen Zusammenhang zwischen Absorption und Konzentration dar.

Zur Bestimmung der Konzentration an SiH-Gruppen wurden verschiedene Ansätze mit unterschiedlichen, aber bekannten Mischungsverhältnissen und Aushärtezuständen untersucht. Es wurde ein jeweils gleichmäßiger Film der zu untersuchenden Probe auf eine KBr-Tablette aufgebracht. Aus dem Rückgang der Extinktion kann auf den Rest-SiH-Gehalt geschlossen und die maximal mögliche Wasserstoffmenge bestimmt werden.

Als Polydiorganosiloxan, das heißt als Komponente A, wurde Elastosil RT 601 oder Sylgard 184 verwendet.

Sylgard 184 kann von der Firma Dow Corning unter der Sachnummer 729790 und Elastosil RT 601 von der Firma Wacker-Chemie unter der Sachnummer 069025 bezogen werden.

Als Härter, das heißt als Komponente B, wurde Wasserstoffsiloxan der Summenformel CH₃-[SiHCH₃O]ₓ -CH₃ eingesetzt.

Als Kontrollexperiment wurde das herkömmlicherweise verwendete Verhältnis von 9 Teilen Elastosil RT 601 zu einem Teil Härter bzw. 10 Teilen Sylgard 184 zu einem Teil Härter eingesetzt (vergleiche letzte Spalte in Tabelle 1, "Herstellerangabe")(alle Verhältnisse sind im folgenden in Gew.% zu Gew.% angegeben). Zur Überprüfung der Nachweisempfindlichkeit wurde ein Verhältnis von 9 Teilen Elastosil RT 601 und 0,026 Teilen Härter bzw. von 10 Teilen Sylgard 184 und 0,0146 Teilen Härter eingesetzt.

Die erfindungsgemäßen Verhältnisse betrugen 9:0,5, 9:0,4 und 9:0,35 Teile Elastosil RT 601 zu Härter, das heißt die Komponenten A und B wurden in den angegebenen Verhältnissen miteinander gemischt und anschließend 1 Stunde entweder bei 80°C oder 150°C ausgehärtet.

Für jede der vorgenannten Mischungen wurden die Zustände unausgehärtet, ausgehärtet nach 1 Stunde 80°C und ausgehärtet nach 1 Stunde 150°C untersucht.

Die Ergebnisse sind in der folgenden Tabelle 1 dargestellt.

**Tabelle 1:**

| Proben-Nr. | Polydiorganosiloxan | Mischungsverhältnis A:B | Aushärtung | Extinktion | Rest Härtergehalt der Einwaage | freier Härtergehalt* | Rest Härtergehalt** |
|---|---|---|---|---|---|---|---|
| a | RT601 | 9:0,026 | ungehärtet | 0,0027 | 100% | 0,29% | 1,0% |
| b | RT601 | 9:0,026 | gehärtet | 0 | 0% | 0% | 0,0% |
| 1. | RT601 | 9:0,35 | ungehärtet | 0,0851 | 100% | 3,74% | 30,8% |
| 2. | RT601 | 9:0,35 | 1h 80°C | --- | --- | --- | --- |
| 3. | RT601 | 9:0,35 | 1h 150°C | 0,007 | 8% | 0,31% | 2,5% |
| 4. | RT601 | 9:0,4 | ungehärtet | 0,101 | 100% | 4,26% | 36,6% |
| 5. | RT601 | 9:0,4 | 1h 80°C | 0,031 | 31% | 1,31% | 11,2% |
| 6. | RT601 | 9:0,4 | 1h 150°C | 0,013 | 13% | 0,55% | 4,7% |
| 7. | RT601 | 9:0,5 | ungehärtet | 0,12 | 100% | 5,26% | 43,5% |
| 8. | RT601 | 9:0,5 | 1h 80°C | 0,039 | 33% | 1,71% | 14,1% |
| 9. | RT601 | 9:0,5 | 1h 150°C | 0,0196 | 16% | 0,86% | 7,1% |
| 10. | RT601 | 9:0,5 | 24h 200°C | 0 | 0% | 0% | 0,0% |
| 11. | RT601 | 9:1 | ungehärtet | 0,276 | 100% | 10% | 100,0% |
| 12. | RT601 | 9:1 | 1h 80°C | 0,167 | 61% | 6,05% | 60,5% |
| 13. | RT601 | 9:1 | 24h 200°C | 0,002 | 1% | 0,07% | 0,7% |
| c | Sylgard 184 | 10:0,0146 | ungehärtet | 0,0024 | 100% | 0,15% | 1,6% |
| d | Sylgard 184 | 10:0,0146 | ausgehärtet | 0 | 0% | 0% | 0,0% |
| 14. | Sylgard 184 | 10:1 | ungehärtet | 0,154 | 100% | 9,09% | 100,0% |
| 15. | Sylgard 184 | 10:1 | 1h 80°C | 0,0749 | 49% | 4,42% | 48,6% |
| 16. | Sylgard 184 | 10:1 | 1h 200°C | 0,0575 | 37% | 3,39% | 37,3% |
| 17. | Sylgard 184 | 10:1 | 2h 200°C | 0,0528 | 34% | 3,12% | 34,3% |
| 18. | Sylgard 184 | 10:1 | 24h 200°C | 0,0188 | 12% | 1,11% | 12,2% |

| | | | | | | | |
|---|---|---|---|---|---|---|---|
| Rest-Härtergehalt in Abhängigkeit der Aushärtung und des Mischungsverhältnisses ( *freier Härtergehalt der Mischung vor bzw. nach der Aushärtung; | | | | | | | |
| **bezogen auf Härterzugabe nach Herstellerangabe) | | | | | | | |

Der Tabelle 1 kann entnommen werden, daß der freie Härtergehalt bei den erfindungsgemäßen Mischungsverhältnissen erheblich geringer als bei den konventionellen Mischungsverhältnissen ist. Die Tabelle zeigt ferner, daß durch Erhöhung der Aushärtetemperatur von 80°C auf 150°C eine weitere Reduktion des freien Härtergehaltes erreicht wird. Die erfindungsgemäßen Mischungsverhältnisse gemäß derer nur ca. 40 - 50% der üblicherweise verwendeten Härtermenge bezogen auf eine bestimmte Menge an Komponente A verwendet werden und/oder die erfindungsgemäß erhöhte Aushärtetemperatur führt daher zu einem beachtlich reduzierten freien Härtergehalt in dem additionsvernetzten Silikonkautschuk, so daß die Wasserstoffbildung erheblich reduziert wird.

### Beispiel 2: Bestimmung der Wasserstoffausgasung

Zur Bestimmung der Wasserstoffausgasung wurde ein H-Analysator der Firma Leybold Heraeus mit einer Empfindlichkeit von 0,1 ppm eingesetzt. Der Wasserstoffgehalt wird bei diesem Gerät über die Änderung der Wärmeleitfähigkeit eines Sensors bestimmt. Die Bestimmung der Wasserstoffausgasung wurde bei Prüftemperaturen von 90°C und 220°C gewählt, da bekannt ist, daß Eisen erst oberhalb von 180°C den gelösten Wasserstoff abgibt. Die übliche Meßdauer betrug 3 Minuten. Diese wird bei vorhandenem Meßsignal automatisch verlängert. Zur Probenvorbereitung wurden die eisenhaltigen Absorbermaterialien unmittelbar vor der Messung in einem Mörser zerrieben. Die ungefüllten Absorbermaterialien wurden in kleine Stücke geschnitten.

Folgende Mischungsverhältnisse wurden untersucht:
A) Elastosil RT601 gefüllt mit jeweils 82% Eisenpulver:
   Mischungsverhältnis 9:0,35 und 9:0,5 (Komponente A:B) sowie das herkömmliche Mischungsverhältnis von 9:1 als Kontrolle.
   Elastosil RT601 ungefüllt: 9:0,35 und 9:0,5.

   Die Aushärtung wurde eine Stunde bei 80°C oder eine Stunde bei 150°C durchgeführt.
B) Sylgard 184 gefüllt mit 82 % Eisenpulver:
   Mischungsverhältnis 10:1 (Komponente A:B) bei einer Aushärtetemperatur von 80°C für eine Stunde als Kontrolle und Mischungsverhältnis von 10:1 bei einer Aushärtetemperatur von 150°C für eine Stunde.
   Sylgard 184 ohne Eisenpulver: Mischungsverhältnis 10:1.

Zunächst wurde der maximal mögliche Wasserstoffgehalt über das Molgewicht des SiH-haltigen Härters bestimmt. Dabei wurde von der Summenformel CH₃-[SiHCH₃O]ₓ-CH₃ ausgegangen. Wenn x eine große Zahl ist, können die beiden endständigen Methylgruppen vernachlässigt werden.

Aus der folgenden Tabelle 2 kann das Molgewicht der einzelnen Elemente entnommen werden.

**Tabelle 2:**

| Zusammensetzung des Molgewichtes | | | |
|---|---|---|---|
| Element | Anzahl | Atomgewicht | Molgewicht in Gramm |
| Si | 1 | 28 | 28 |
| C | 1 | 12 | 12 |
| O | 1 | 16 | 16 |
| H | 4 | 1 | 4 |
| Summe | | | 60 |

Da nur das an das Siliciumatom gebundene Wasserstoffatom abgespalten werden kann, können pro 60 Gramm Härter nur 2 Gramm Wasserstoff entstehen, wobei jeweils 1 Gramm aus dem Härter und 1 Gramm aus der Feuchtigkeit stammen.

Der folgenden Tabelle 3 kann der maximal abspaltbare Wasserstoffanteil des Absorbermaterials entnommen werden.

**Tabelle 3:**

| Berechneter maximaler Wasserstoffgehalt (die Zeilen H bis K berücksichtigen bereits den Wasserstoffgehalt aus der Reaktion mit der Luftfeuchtigkeit) | | | | | | |
|---|---|---|---|---|---|---|
| | | | | Mischungsverhältnis (A:B) | | |
| Zeile | | | 9:1 | 9:0,5 | 9:0,4 | 9:0,35 |
| A | Harzanteil in gr | Berechnung | 9 | 9 | 9 | 9 |
| B | Härteanteil in gr | | 1 | 0,5 | 0,4 | 0,35 |
| C | Dämpfungsmasse in gr | | 22 | 22 | 22 | 22 |
| D | Silikonanteil | | 18% | 18% | 18% | 18% |
| E | Silikonmasse in gr | C*D | 3,96 | 3,96 | 3,96 | 3,96 |
| F | Härteranteil | B/(A+B) | 10,0% | 5,3% | 4,3% | 3,7% |
| G | Härtermasse in gr | E*F | 0,40 | 0,21 | 0,17 | 0,15 |
| H | Masse Wasserstoff in mgr | 2*1000*G/60 | 13,2 | 6,9 | 5,6 | 4,9 |
| I | Wasserstoffgehalt im ppm unausgehärtet [ungefüllt] | H/C*10° | 600 [3333] | 316 [1756] | 255 [1417] | 225 [1250] |
| J | Wasserstoffgehalt in ppm bei Aushärtung 1 h 80°C [ungefüllt] | I* Resthärtergehalt aus Tabelle 1 | 366 [2033] | 104,0 [578] | 79,0 [439] | --- |
| K | Wasserstoffgehalt in ppm bei Aushärtung 1 h 150°C [ungefüllt] | I* Resthärtergehalt aus Tabelle 1 | --- | 50,5 [281] | 33,2 [184] | 18,0 [100] |

Der Tabelle 3 kann entnommen werden, daß bei den erfindungsgemäßen Mischungsverhältnissen ein erheblich geringerer abspaltbarer Wasserstoffanteil vorliegt. Der Tabelle kann auch entnommen werden, daß bei einer Erhöhung der Aushärtetemperatur dieser Anteil nochmals abnimmt.

Der folgenden Tabelle 4 können die gemessenen Werte für die Wasserstoffausgasung in Abhängigkeit vom Mischungsverhältnis und der Aushärtetemperatur entnommen werden.

**Tabelle 4:**

| Gemessene Ausgaswerte in Abhängigkeit vom Mischungsverhältnis und der Aushärtetemperatur | | | | | | | | |
|---|---|---|---|---|---|---|---|---|
| Nr. | Polydiorganosiloxan | Mischungsverhältnis | Anteil Eisen in gr | Aushärtung | H₂ Ausgasung | | | |
| | | | | | Prüftemp. 90°C | | Prüftemp. 220°C | |
| | | | | | Einwaage in Gramm | Ausgasung in ppm | Einwaage in Gramm | Ausgasung in ppm |
| 1. | RT601 | 9:0,35 | 0 | 1h 80°C | 1,47 | 0 | --- | --- |
| 2. | RT601 | 9:0,35 | 43 | 1h 80°C | --- | --- | 2,01 | 1,2 |
| 3. | RT601 | 9:0,35 | 43 | 1h 150°C | --- | --- | 2,33 | 0,5 |
| 4. | RT601 | 9:0,5 | 0 | 1h 80°C | --- | --- | 0,306 | 12 |
| 5. | RT601 | 9:0,5 | 0 | 1h 150°C | --- | --- | 0,3 | 0,5 |
| 6. | RT601 | 9:0,5 | 43 | 1h 80°C | --- | --- | 1,35 | 3,5 |
| 7. | RT601 | 9:0,5 | 43 | 1h 150°C | --- | --- | 1,37 | 1,5 |
| 8. | RT601 | 9:1 | 0 | 1h 80°C | 1,27 | 0 | 0,33 | 350 |
| 9. | RT601 | 9:1 | 0 | 1h 150°C | --- | --- | 0,33 | 70 |
| 10. | RT601 | 9:1 | 46 | 1h 80°C | 2,5 | 0 | 2,74 | 15,4 |
| 11. | RT601 | 9:1 | 46 | 1h 150°C | --- | --- | 1,7 | 2 |
| 12. | Sylgard 184 | 10:1 | 0 | 1h 80°C | --- | --- | 0,4 | 230 |
| 13. | Sylgard 184 | 10:1 | 50 | 1h 80°C | 1,3 | 0 | 1,62 | 31 |
| 14. | Sylgard 184 | 10:1 | 50 | 1h 150°C | --- | --- | 1,86 | 30 |

Bei einer Prüftempereratur von 90°C konnte keine Wasserstoffausgasung festgestellt werden. Erst bei höheren Temperaturen wird Wasserstoff abgespalten. Mit zunehmendem Härtergehalt nimmt auch die Wasserstoffbildung zu. Durch die erfindungsgemäß vorgesehene Erhöhung der Aushärtetemperatur kann die Wasserstoffabspaltung deutlich reduziert werden. Dies gilt ebenfalls für die erfindungsgemäß vorgesehene Zugabe des Härters im Unterschuß zu der Polydiorganosiloxankomponente, verglichen zu der konventionellen Relation dieser beiden Komponenten. Die Differenz zwischen den gemessenen Werten der Tabelle 4 und den berechneten Werten der Tabelle 3 ergeben sich aus der Zeitabhängigkeit der Reaktion.

### Beispiel 3: Bestimmung der Härte

In diesem Beispiel wurde die Härte nach DIN 53505 bestimmt (in Shore A)

Die folgende Tabelle 5 stellt die Shore-Härte in Abhängigkeit vom Mischungsverhältnis und der Aushärtetemperatur dar.

**Tabelle 5:**

| Shore-A-Härte in Abhängigkeit vom Mischungsverhältnis und der Aushärtetemperatur | | | | | |
|---|---|---|---|---|---|
| Nr. | Polydiorganosiloxan | Mischungsverhältnis | Anteil Eisen in gr | Aushärtung | Härte in Shore A |
| 1. | RT601 | 9:0,35 | 0 | 1h 80°C | 13 |
| 2. | RT601 | 9:0,35 | 0 | 1h 150°C | 20-22 |
| 3. | RT601 | 9:0,35 | 43 | 1h 80°C | 50 |
| 4. | RT601 | 9:0,35 | 43 | 1h 150°C | 57 |
| 5. | RT601 | 9:0,5 | 0 | 1h 80°C | 35 |
| 6. | RT601 | 9:0,5 | 0 | 1h 150°C | 42 |
| 7. | RT601 | 9:0,5 | 43 | 1h 80°C | 74-76 |
| 8. | RT601 | 9:0,5 | 43 | 1h 150°C | 79-81 |
| 9. | RT601 | 9:1 | 0 | 1h 80°C | 50 |
| 10. | RT601 | 9:1 | 0 | 1h 150°C | 52 |
| 11. | RT601 | 9:1 | 46 | 1h 80°C | 83-85 |
| 12. | RT601 | 9:1 | 46 | 1h 150°C | 86-87 |
| 13. | Sylgard 184 | 10:1 | 0 | 1h 80°C | 51-52 |
| 14. | Sylgard 184 | 10:1 | 0 | 1h 150°C | 68 |
| 15. | Sylgard 184 | 10:1 | 50 | 1h 80°C | 86 |
| 16. | Sylgard 184 | 10:1 | 50 | 1h 150°C | 88-89 |
| 17. | Sylgard 184 | 10:0,5 | 0 | 1h 80°C | 25 |
| 18. | Sylgard 184 | 10:0,5 | 0 | 1h 150°C | 32-34 |

Mit zunehmendem Härtergehalt und Aushärtetemperatur steigt die Shore-A-Härte durch einen höheren Vernetzungsgrad. Damit ändern sich auch die mechanischen Eigenschaften wie zum Beispiel die Reißdehnung und die Weiterreißfestigkeit. Durch den Füllstoffgehalt werden diese Eigenschaften jedoch stark angeglichen. Es stellt sich heraus, daß die erfindungsgemäß vorgesehenen Mischungsverhältnisse ebenso wie die erfindungsgemäß vorgesehene höhere Aushärtetemperatur die Härte nicht wesentlich verschlechtern, sondern teilweise sogar verbessern.

### Beispiel 4: Bestimmung der Temperaturbeständigkeit

In diesem Beispiel wurde die Temperaturbeständigkeit der erfindungsgemäßen Absorbermaterialien ohne Eisenfüllung untersucht, wobei die Temperaturbeständigkeit über den Gewichtsverlust bestimmt wurde. In einer Thermowaage wird jeweils eine Probe mit 20 K/min von Raumtemperatur bis 850°C aufgeheizt und dabei kontinuierlich der Gewichtsverlust bestimmt. Als Spülgas wird Luft verwendet. Die Art der Aushärtung hat hierbei Einfluß auf die Temperaturbeständigkeit des Absorbermaterials.

Die Tabelle 6 stellt die Temperaturbeständigkeit der erfindungsgemäßen Absorbermaterialien in Abhängigkeit vom Mischungsverhältnis und der Aushärtetemperatur dar.

**Tabelle 6:**

| Temperaturbeständigkeit in Abhängigkeit vom Mischungsverhältnis und der Aushärtetemperatur. | | | | |
|---|---|---|---|---|
| Nr. | Polydiorganosiloxan | Mischungsverhältnis (A:B) | Aushärtung | Beginn Gewichtsverlust in °C |
| 1. | RT601 | 9:0,35 | 1h 80°C | 196 |
| 2. | RT601 | 9:0,35 | 1h 150°C | 216 |
| 3. | RT601 | 9:0,5 | 1h 80°C | 220 |
| 4. | RT601 | 9:0,5 | 1h 150°C | 220 |
| 5. | RT601 | 9:1 | 1h 80°C | 208 |
| 6. | RT601 | 9:1 | 1h 150°C | 212 |
| 7. | Sylgard 184 | 10:0,5 | 1h 80°C | 216 |
| 8. | Sylgard 184 | 10:0,5 | 1h 150°C | 220 |
| 9. | Sylgard 184 | 10:1 | 1h 80°C | 208 |
| 10. | Sylgard 184 | 10:1 | 1h 150°C | 228 |

Bei sehr niedrigen und sehr hohen Härterzugaben beginnen bereits unterhalb von 200°C niedermolekulare Bestandteile abzugasen. Bei hohen Aushärtetemperaturen werden diese bereits mit der Aushärtung ausgetrieben. Einen sehr niedrigen Bestand an niedermolekularen Bestandteilen erhält man bei Elastosil RT608 bei einem Mischungsverhältnis von 9:0,5 und bei Sylgard 184 bei einem Mischungsverhältnis von 10:0,5. Die Temperaturbeständigkeit der erfindungsgemäßen Absorbermaterialien ist vergleichbar oder sogar besser als die der von herkömmlichen Absorbermaterialien.

### Beispiel 5: Bestimmung des Materialschrumpfs

Zur Bestimmung des Materialsschrumpfs wurde ein Mischungsverhältnis von 9 Teilen Elastosil RT601 zu 0,4 Teilen Wasserstoffsiloxan verwendet. Der Silikonkautschuk wies einen Eisengehalt von 82% auf. Die Aushärtung wurde über eine Stunde bei 150°C durchgeführt. Der für die Ermittlung des Materialschrumpfs eingesetzte Aluminiumrahmen des Werkzeugs weist Maße von 100 mm x 10 mm x 5 mm auf.

Zur Ermittlung des freien Schrumpfs wurde der Rahmen auf ein chromatiertes Aluminiumblech gespannt, mit dem Absorbermaterial gefüllt und ausgehärtet. Das Material haftet nicht auf dem Rahmen und dem Blech. Aus der Differenz zwischen Werkzeugmaß und Teilemaß wird der Materialschrumpf berechnet. Zur Ermittlung eines behinderterten Schrumpfs wurde das Aluminiumblech zusätzlich mit einer Grundierung G790 grundiert. Das Absorbermaterial haftet demgemäß auf dem Aluminiumblech.

Die Ergebnisse dieser Experimente sind in der Tabelle 7 dargestellt.

**Tabelle 7:**

| Materialschrumpf | | |
|---|---|---|
| Beschreibung | freier Schrumpf | behinderter Schrumpf |
| Werkzeugmaß | 100,0 mm | 100,0 mm |
| Teilemaß | 98,15 mm | 99,78 |
| Differenz | 1,85 mm | 0,22 |
| Schrumpf | 1,85% | 0,22% |

Wird das Absorbermaterial auf eine Fläche aufgegossen, auf der es wegen der Verwendung eines Haftvermittlers haftet, so wird der Schrumpf behindert. Aus diesem Grund müssen die Trägerbleche eine genügende Steifigkeit besitzen, um die auftretenden Schrumpfspannungen aufnehmen zu können. Je höher die Aushärtetemperatur, um so höher ist auch der Schrumpf.

## Patentansprüche

1. Verwendung eines additionsvernetzten Silkonkautschuks als Absorbermaterial mit verringerter Wasserstoffemission zur Absorbtion von hochfrequenten elektromagnetischen Wellen, **dadurch gekennzeichnet, daß** das Absorbermaterial aus einem Polyorganosiloxan und einem siliciumwasserstoff-gruppenhaltigen Härter hergestellt wird, wobei in einem ersten Verfahrensschritt der Härter dem Polyorganosiloxan im Unterschuß zugesetzt und in einem zweiten Verfahrensschritt der ausgehärtete additionsvernetzte Silikonkautschuk erhalten wird, so daß der additionsvernetzte Silikonkautschuk im wesentlichen keine freien Siliciumwasserstoffgruppen aufweist.

2. Verwendung nach Anspruch 1, **dadurch gekennzeichnet, daß** der zweite Verfahrensschritt bei einer Temperatur von 140 Grad Celsius bis 180 Grad Celsius, vorzugsweise von 150 Grad Celsius, über einen Zeitraum von 0,5 bis 3 Stunden, vorzugsweise 1 Stunde, durchgeführt wird.

3. Verwendung eines additionsvernetzten Silkonkautschuks als Absorbermaterial mit verringerter Wasserstoffemission zur Absorbtion von hochfrequenten elektromagnetischen Wellen, **dadurch gekennzeichnet, daß** das Absorbermaterial aus einem Polyorganosiloxan und einem siliciumwasserstoff-gruppenhaltigen Härter hergestellt wird, wobei in einem ersten Verfahrensschritt der Härter dem Polyorganosiloxan zugesetzt und in einem zweiten Verfahrensschritt bei einer Temperatur von 140 Grad Celsius bis 180 Grad Celsius, vorzugsweise von 150 Grad Celsius, über einen Zeitraum von 0,5-bis 3 Stunden, vorzugsweise 1 Stunde, ausgehärtet und ein ausgehärteter additionsvernetzter Silikonkautschuk erhalten wird, so daß der additionsvernetzte Silikonkautschuk im wesentlichen keine freien Siliciumwasserstoffgruppen aufweist.

4. Verwendung nach einem der vorhergehenden Ansprüche, wobei der siliciumwasserstoffgruppenhaltige Härter Wasserstoffsiloxan der Summenformel CH₃- [SiHCH₃O]ₓ - CH₃ ist.

5. Verwendung nach einem der vorhergehenden Ansprüche, wobei das Gewichtsverhältnis von Polyorganosiloxan zu siliziumwasserstoffgruppenhaltigem Härter 30:1 bis 15:1, vorzugsweise 26:1 bis 18:1, beträgt.

6. Verwendung nach einem der vorhergehenden Ansprüche, **dadurch gekennzeichnet, daß** das Absorbermaterial Eisenpulver enthält.

7. Halbleiteranordnung, umfassend einen in einem hermetisch dichten Gehäuse angeordneten Halbleiter, **dadurch gekennzeichnet, daß** in dem Gehäuse ein Absorbermaterial als Dämpfungsmasse zur Absorbtion von hochfrequenten elektromagnetischen Wellen, angeordnet ist, wobei das Absorbermaterial einen additionsvernetzten Silikonkautschuk und gegebenenfalls Eisenpulver enthält und der additionsvernetzte Silikonkautschuk im wesentlichen keine freien Siliciumwasserstoffgruppen aufweist.

## Claims

1. Use of an additional-crosslinked silicone rubber as absorber material with reduced hydrogen emission for the absorption of high-frequency electromagnetic waves, **characterized in that** the absorber material is prepared from a polyorganosiloxane and from a curing agent containing silane groups, where, in a first step of a process, a substoichiometric amount of the curing agent is added to the polyorganosiloxane, and in a second step of a process the cured addition-crosslinked silicone rubber is obtained, in such a way that the addition-crosslinked silicone rubber substantially has no free silane groups.

2. Use according to Claim 1, **characterized in that** the second step of the process is carried out at a temperature of from 140 degrees Celsius to 180 degrees Celsius, preferably from 150 degrees Celsius, for a period of from 0.5 to 3 hours, preferably 1 hour.

3. Use of an addition-crosslinked silicone rubber as absorber material with reduced hydrogen emission for the absorption of high-frequency electromagnetic waves, **characterized in that** the absorber material is prepared from a polyorganosiloxane and from a curing agent containing silane groups, where in a first step of a process the curing agent is added to the polyorganosiloxane, and in a second step of a process cures at a temperature of from 140 degrees Celsius to 180 degrees Celsius, preferably from 150 degrees Celsius, over a period of from 0.5 to 3 hours, preferably 1 hour, and a cured addition-crosslinked silicone rubber is obtained, in such a way that the addition-crosslinked silicone rubber substantially has no free silane groups.

4. Use according to any of the preceding claims, where the curing agent containing silane groups is a hydrosiloxane of the empirical formula CH₃-[SiHCH₃O]ₓ-CH₃.

5. Use according to any of the preceding claims, where the ratio by weight of polyorganosiloxane to curing agent containing silane groups is from 30:1 to 15:1, preferably from 26:1 to 18:1.

6. Use according to any of the preceding claims, **characterized in that** the absorber material comprises iron powder.

7. Semiconductor arrangement, encompassing a semiconductor arranged in a hermetically sealed housing, **characterized in that** in the housing an absorber material has been arranged as insulating composition for the absorption of high-frequency electromagnetic waves, where the absorber material comprises an addition-crosslinked silicone rubber and, where appropriate, iron powder, and the addition-crosslinked silicone rubber substantially has no free silane groups.

## Revendications

1. Application d'un caoutchouc de silicone réticulé par addition comme matière absorbante à émission réduite d'hydrogène pour absorber des ondes électromagnétiques à haute fréquence,
**caractérisée en ce que**
la matière absorbante est fabriquée à partir d'un polyorganosiloxane et d'un durcisseur contenant des groupes d'hydrure de silicium, et
dans une première étape de procédé on ajoute le durcisseur au polyorganosiloxane en excédent et dans une seconde étape du procédé on obtient le caoutchouc de silicone, réticulé par addition, durci, de façon que le caoutchouc de silicone réticulé par addition, ne présente pratiquement pas de groupes libres d'hydrure de silicium.

2. Application selon la revendication 1,
**caractérisée en ce que**
la seconde étape du procédé se fait à une température de 140°C-180°C et de préférence 150°C pendant une durée de 0,5 à 3 heures et de préférence 1 heure.

3. Application d'un caoutchouc de silicone réticulé par addition comme matière absorbante à émission réduite d'hydrogène pour l'absorption d'ondes électromagnétiques à haute fréquence,
**caractérisée en ce que**
la matière absorbante est fabriquée à partir d'un polyorganosiloxane et d'un durcisseur contenant des groupes d'hydrure de silicium,
selon lequel dans une première étape de procédé on ajoute le durcisseur au polyorganosiloxane et dans une seconde étape de procédé, à une température comprise entre 140°C et 180°C, de préférence à 150°C, on laisse prendre pendant une durée de 0,5 à 3 heures et de préférence 1 heure, et on obtient un caoutchouc de silicone réticulé par addition, durci, de façon que le caoutchouc de silicone réticulé par addition ne présente pratiquement pas de groupes d'hydrure de silicium libres.

4. Application selon l'une quelconque des revendications précédentes,
**caractérisée en ce que**
le durcisseur contenant des groupes d'hydrure de silicium est un siloxane d'hydrogène correspondant à la formule globale CH₃ - [SIHCH₃O]ₓ - CH₃.

5. Application selon l'une quelconque des revendications précédentes dans laquelle
le rapport pondéral du polyorganosiloxane au durcisseur contenant des groupes d'hydrure de silicium correspond à 30 :1-15 :1 et de préférence 26 :1-18 :1.

6. Application selon l'une quelconque des revendications précédentes,
**caractérisée en ce que**
la matière absorbante contient de la poudre de fer.

7. Dispositif semi-conducteur comportant un semi-conducteur placé dans un boîtier fermé de manière hermétique,
**caractérisé en ce que**
le boîtier contient une matière absorbante comme masse d'amortissement pour absorber des ondes électromagnétiques à haute fréquence,
la matière absorbante contient un caoutchouc de silicone réticulé par addition et le cas échéant de la poudre de fer et le caoutchouc de silicone réticulé par addition ne présente pratiquement pas de groupes d'hydrure de silicium libres.
